(19) 

Europäisches Patentamt

European Patent Office

Office européen des brevets

(11) **EP 4 306 603 A1**

(12) **EUROPEAN PATENT APPLICATION**
published in accordance with Art. 153(4) EPC

(43) Date of publication:
**17.01.2024 Bulletin 2024/03**

(21) Application number: **22767021.3**

(22) Date of filing: **04.03.2022**

(51) International Patent Classification (IPC):
*C09D 201/00* (2006.01)   *H01L 21/60* (2006.01)
*C09D 7/40* (2018.01)   *C09D 7/61* (2018.01)
*C09D 7/65* (2018.01)   *H05K 3/00* (2006.01)
*H05K 3/28* (2006.01)

(52) Cooperative Patent Classification (CPC):
**C09D 7/40; C09D 7/61; C09D 7/65; C09D 201/00;
H01L 21/60; H05K 3/00; H05K 3/28;**
H01L 2224/83951

(86) International application number:
**PCT/JP2022/009377**

(87) International publication number:
**WO 2022/191063 (15.09.2022 Gazette 2022/37)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **11.03.2021   JP 2021039341
09.02.2022   JP 2022018377**

(71) Applicant: **SEKISUI CHEMICAL CO., LTD.**
**Osaka-shi**
**Osaka**
**530-8565 (JP)**

(72) Inventors:
• **KAMIYAMA, Akira**
  **Ritto-shi, Shiga 520-3027 (JP)**
• **KUROZUMI, Satoru**
  **Ritto-shi, Shiga 520-3027 (JP)**

(74) Representative: **Ter Meer Steinmeister & Partner
Patentanwälte mbB
Nymphenburger Straße 4
80335 München (DE)**

(54) **COATING AGENT MANUFACTURING KIT, COATING AGENT, AND METHOD FOR PRODUCING ELECTRONIC SUBSTRATE AND ELECTRONIC COMPONENT MODULE**

(57)    Provided is a coating agent preparation kit with which a coating agent layer having a desired thickness can be satisfactorily obtained and a coating film can be easily formed. A coating agent preparation kit according to the present invention is a coating agent preparation kit for obtaining a coating agent by mixing, the coating agent preparation kit including a first composition and a second composition, the first composition including a curable compound curable with ultraviolet rays, heat, or moisture, and the second composition including hollow particles.

[FIG. 1]

**Description**

**TECHNICAL FIELD**

The present invention relates to a coating agent preparation kit. The present invention also relates to a coating agent. The present invention also relates to an electronic substrate in which the coating agent is used. The present invention also relates to a method for producing an electronic component module using the coating agent.

**BACKGROUND ART**

Electronic components in which electronic devices such as semiconductor devices and connection terminals are mounted on a circuit board are widely used. Typically, the circuit board and the electronic devices are electrically connected by solder. In addition, for the purpose of protecting the electronic components from moisture and preventing occurrence of whisker and a short circuit accompanying oxidation of the circuit of the board, a coating film formed of a coating agent is disposed on at least a part of the surface of the electronic component.

For example, Patent Document 1 below discloses a vehicle-mounted control device including a circuit board, an electronic component mounted on the circuit board, solder that electrically brings a terminal of the electronic component into contact with the circuit board, and a coating film that protects at least a part of the circuit board. In the vehicle-mounted control device, the coating film covers the terminal and the solder and has a loss modulus at 125°C of $1.0 \times 10^5$ Pa or more.

**Related Art Document**

**Patent Document**

Patent Document 1: WO 2017/038343 A1

**SUMMARY OF THE INVENTION**

**PROBLEMS TO BE SOLVED BY THE INVENTION**

An electronic substrate in which a surface of a solder part formed by solder is covered with a cured product (coating film) of a coating agent is used. The electronic substrate may be produced by disposing the coating agent on the surface of the solder part and then curing the coating agent. As the coating agent, a coating agent containing a relatively large amount of organic solvent has been conventionally used. With the conventional coating agent containing a relatively large amount of organic solvent, it is difficult to increase the thickness of the coating agent layer. Thus, it is necessary to repeatedly apply the coating agent many times to form a coating agent layer having a desired thickness. In addition, the conventional coating agent containing a relatively large amount of organic solvent requires a drying step to volatilize the organic solvent. Thus, with the conventional coating agent containing a relatively large amount of organic solvent, the production efficiency of the electronic substrate decreases.

An object of the present invention is to provide a coating agent preparation kit and a coating agent with which a coating agent layer having a desired thickness can be satisfactorily obtained and a coating film can be easily formed. Another object of the present invention is to provide an electronic substrate in which the coating agent is used and a method for producing an electronic component module.

**MEANS FOR SOLVING THE PROBLEMS**

According to a broad aspect of the present invention, there is provided a coating agent preparation kit for obtaining a coating agent by mixing, the coating agent preparation kit including a first composition and a second composition, the first composition including a curable compound curable with ultraviolet rays, heat, or moisture, and the second composition including hollow particles.

In a specific aspect of the coating agent preparation kit according to the present invention, the curable compound has a viscosity at 25°C of 50 mPa·s or more and 3,000 mPa·s or less.

In a specific aspect of the coating agent preparation kit according to the present invention, a coating agent obtained by mixing the first composition and the second composition has a viscosity at 25°C of 100 mPa·s or more and 30,000 mPa·s or less.

According to a broad aspect of the present invention, there is provided a coating agent including a curable compound curable with ultraviolet rays, heat, or moisture, and hollow particles.

In a specific aspect of the coating agent preparation kit according to the present invention, the curable compound has a viscosity at 25°C of 50 mPa·s or more and 3,000 mPa·s or less, and the coating agent has a viscosity at 25°C of 100 mPa·s or more and 30,000 mPa·s or less.

In a specific aspect of the coating agent according to the present invention, the hollow particles are balloon particles or porous hollow particles, when the balloon particles are contained, a content of the balloon particles is 0.5 wt% or more and 50 wt% or less in 100 wt% of the coating agent, and when the porous hollow particles are contained, a content of the porous hollow particles is 5 wt% or more and 40 wt% or less in 100 wt% of the coating agent.

In a specific aspect of the coating agent according to the present invention, the hollow particles include balloon particles and porous hollow particles, a content of the balloon particles is 0.5 wt% or more and 10 wt% or less in 100 wt% of the coating agent, and a content of the porous hollow particles is 5 wt% or more and 40 wt% or less in 100 wt% of the coating agent.

In a specific aspect of the coating agent according to the present invention, the hollow particles have a hollow rate of 40 vol% or more and 99 vol% or less.

In a specific aspect of the coating agent according to the present invention, the hollow particles contain polyacrylonitrile or an acrylic resin.

In a specific aspect of the coating agent according to the present invention, the curable compound includes a first curable compound curable with ultraviolet rays.

In a specific aspect of the coating agent according to the present invention, the first curable compound is curable with ultraviolet rays and curable with heat or moisture.

In a specific aspect of the coating agent according to the present invention, the coating agent is a coating agent for a circuit board.

According to a broad aspect of the present invention, there is provided an electronic substrate including a circuit board, a solder part disposed on a surface of the circuit board, and a coating film covering the solder part, the coating film being a cured product of the coating agent described above.

In a specific aspect of the electronic substrate according to the present invention, the electronic substrate includes an electronic device mounted on the circuit board, and the circuit board and the electronic device are electrically connected by the solder part.

In a specific aspect of the electronic substrate according to the present invention, in a thickness direction of the coating film, the hollow particles are unevenly distributed to be abundantly present on a surface side opposite to the solder part side.

In a specific aspect of the electronic substrate according to the present invention, the coating film includes a first layer and a second layer, a content of the hollow particles is less than 1.0 wt% in 100 wt% of the first layer, and a content of the hollow particles is 1.0 wt% or more in 100 wt% of the second layer.

In a specific aspect of the electronic substrate according to the present invention, in the coating film, the first layer is positioned closer to the solder part than the second layer is.

According to a broad aspect of the present invention, there is provided a method for producing an electronic component module, the method including a step of preparing an electronic component in which an electronic device is mounted on a circuit board and the circuit board and the electronic device are electrically connected to each other by a conductive bonding part, a step of disposing the coating agent described above on a surface of the electronic component to cover at least the conductive bonding part, a step of forming a coating film by curing the coating agent, and a step of disposing, in a mold, the electronic component on which the coating film is formed and performing injection molding to seal, with a thermoplastic resin, the electronic component on which the coating film is formed.

In a specific aspect of the method for producing an electronic component module according to the present invention, the conductive bonding part is a solder part.

**EFFECT OF THE INVENTION**

The coating agent preparation kit according to the present invention is a coating agent preparation kit for obtaining a coating agent by mixing. The coating agent preparation kit according to the present invention includes a first composition and a second composition, the first composition including a curable compound curable with ultraviolet rays, heat, or moisture, and the second composition including hollow particles. The coating agent preparation kit according to the present invention, having the above-described configurations, can satisfactorily obtain a coating agent layer having a desired thickness and can easily form a coating film.

The coating agent according to the present invention includes a curable compound curable with ultraviolet rays, heat, or moisture, and hollow particles. The coating agent according to the present invention, having the above-described configurations, can satisfactorily obtain a coating agent layer having a desired thickness and can easily form a coating film.

**BRIEF DESCRIPTION OF DRAWINGS**

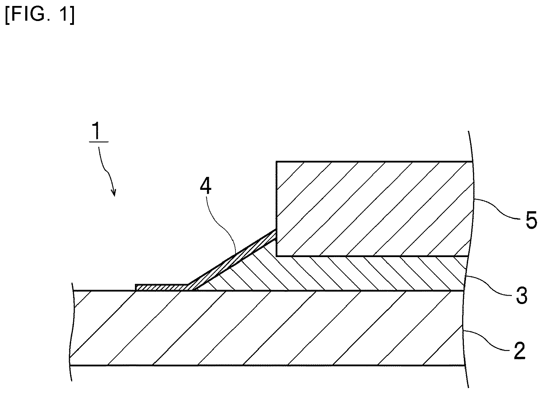

[Fig. 1] Fig. 1 is a sectional view schematically illustrating an electronic substrate in which a coating agent according to an embodiment of the present invention is used.

**MODES FOR CARRYING OUT THE INVENTION**

Hereinafter, details of the present invention will be described.

(Coating agent preparation kit and coating agent)

The coating agent preparation kit according to the present invention is a coating agent preparation kit for obtaining a coating agent by mixing. The coating agent preparation kit according to the present invention includes a first composition and a second composition, the first composition including a curable compound curable with ultraviolet rays, heat, or moisture, and the second composition including hollow particles.

The coating agent according to the present invention includes a curable compound curable with ultraviolet rays, heat, or moisture, and hollow particles.

The coating agent preparation kit and the coating agent according to the present invention, having the above-described configurations, can satisfactorily obtain a coating agent layer having a desired thickness and can easily form a coating film.

With a conventional coating agent containing a relatively large amount of organic solvent, it is difficult to increase the thickness of a coating agent layer obtained by applying the coating agent. Thus, it is necessary to repeatedly apply the coating agent many times to form a coating agent layer having a desired thickness. In addition, the conventional coating agent containing a relatively large amount of solvent requires a drying step to volatilize the solvent. Thus, with the conventional coating agent containing a relatively large amount of solvent, the production efficiency of the electronic substrate decreases. In contrast, in the present invention, since the coating agent does not contain a solvent or the content of the solvent in the coating agent can be reduced, a coating agent layer having a desired thickness can be favorably obtained, and the drying step can be omitted. With the present invention, a relatively thick coating agent layer can be satisfactorily obtained. In addition, since the coating agent layer can be quickly cured by ultraviolet irradiation or the like, a film can be easily formed. Thus, the present invention can increase the production efficiency of the electronic substrate.

The obtained electronic substrate and resin may be subjected to injection molding to seal the electronic components in the electronic substrate with the resin. However, with a conventional coating agent, the heat insulating properties of the coating may be uneven. For this reason, in the electronic substrate including a coating film formed of the conventional coating agent, the heat of molten resin is easily transferred to the solder through a part of the coating film having a large thermal conductivity during injection molding, and the solder may be partially remelted. When the solder is remelted, the electronic components may be damaged.

The coating agent preparation kit and the coating agent according to the present invention, having the above-described configurations, can form a coating film having uniform heat insulating properties and can reduce damage of the electronic component due to partial remelting of the solder. In the present invention, a coating film having uniform heat insulating properties can be suitably formed by disposing the coating agent on a surface of the solder part and then curing the coating agent, for example. Thus, the solder is less likely to be remelted, and damage of the electronic component can be reduced even when injection molding is performed using an electronic substrate or the like having the above coating film.

The coating agent preparation kit and the coating agent according to the present invention, having the above-described configurations, can also effectively reduce damage of the electronic components due to heat conduction from the molten resin (resin for sealing the electronic components) used in injection molding.

It is conceivable to use a foaming agent, such as a solid foaming agent or a liquid foaming agent, to lower the thermal conductivity of the coating film. However, when a foaming agent is simply used, the air bubbles in the coating film are likely to be open bubbles instead of closed bubbles, and it is also difficult to control the size of the voids in the coating film. In particular, in a part where a void having a large size is generated by open bubbles, the electric resistance significantly decreases.

With the coating agent preparation kit and the coating agent according to the present invention, in which hollow particles are used, it is possible to control the size of voids in the coating film, and open bubbles are hardly generated.

In the coating agent preparation kit, a coating agent may be obtained by mixing the first composition and the second composition. The first composition is a first mixing material. The second composition is a second mixing material. In the coating agent preparation kit, a coating agent containing the curable compound and the hollow particles may be obtained by mixing the first composition and the second composition. The first composition is preferably contained in a first container. The second composition is preferably contained in a second container. The first composition may contain only the curable compound, may be a composition composed of the curable compound, or may contain a component other than the curable compound. In the present specification, the first mixing material containing only one kind of the curable compound is also referred to as a composition. The second composition may contain only the hollow particles, may be a composition composed of the hollow particles, or may contain components other than the hollow particles. In the present specification, the second mixing material containing only one kind of the hollow particles is also referred to as a composition. The coating agent preparation kit may be a two-agent type kit having the first composition and the second composition or may be a three-agent type kit having a third composition contained in a third container in addition to the first composition and the second composition. When the coating agent preparation kit is a three-agent type kit, a coating agent may be obtained by mixing the first composition, the second composition, and the third composition. From the viewpoint of improving the handleability, the coating agent preparation kit is preferably a two-agent type kit having the first composition and the second composition.

Hereinafter, the components used in the coating agent preparation kit and the coating agent according to the present invention will be described. In the following description, "(meth)acryl" means one or both of "acryl" and "methacryl", "(meth)acryloyl" means one or both of "acryloyl" and "methacryloyl", and "(meth)acrylate" means one or both of "acrylate" and "methacrylate". An acrylic compound means a (meth)acrylic compound, an acrylic resin means a (meth)acrylic resin, and an acrylate compound means a (meth)acrylate compound.

<Curable compound>

In the coating agent preparation kit, the first composition contains a curable compound curable with ultraviolet rays, heat, or moisture. The coating agent contains a curable compound curable with ultraviolet rays, heat, or moisture. One kind of the curable compound may be used alone, or two or more kinds thereof may be used in combination.

The curable compound may be a monomer, an oligomer, or a polymer. The curable compound preferably contains a monomer or an oligomer, and more preferably contains a monomer and an oligomer.

The curable compound may include a curable compound curable with ultraviolet rays (ultraviolet curable compound), may contain a curable compound curable with heat (thermosetting compound), or may contain a curable compound curable with moisture (moisture curable compound).

The curable compound curable with ultraviolet rays has an ultraviolet curable functional group. The curable compound curable with heat has a thermosetting functional group. The curable compound curable with moisture has a moisture curable functional group.

Examples of the ultraviolet curable functional group include an ethylenically unsaturated bond group, an epoxy group, a vinyl ether group, a glycidyl ether group, and an oxetanyl group. Examples of the ethylenically unsaturated bond group include a (meth)acryloyl group, a vinyl group, and an allyl group.

Examples of the thermosetting functional group include an epoxy group, a carboxy group, a hydroxy group, and an isocyanate group.

Examples of the moisture curable functional group include a hydrolyzable silyl group, a cyano (meth)acrylate group, and an isocyanate group. Examples of the hydrolyzable silyl group include an alkoxysilyl group. Examples of the alkoxysilyl group include trialkoxysilyl groups such as trimethoxysilyl group, triethoxysilyl group, triisopropoxysilyl group, and triphenoxysilyl group; dialkoxysilyl groups such as propyldimethoxysilyl group, methyldimethoxysilyl group, and methyldiethoxysilyl group; and monoalkoxysilyl groups such as dimethylmethoxysilyl group and dimethylethoxysilyl group.

From the viewpoint of increasing the curing speed of the coating agent, the curable compound preferably includes a first curable compound curable with ultraviolet rays. The first curable compound has an ultraviolet curable functional group. The first curable compound may be a curable compound curable with heat or moisture (first curable compound (A)), or may be a curable compound curable with heat or moisture (first curable compound (B)).

From the viewpoint of enhancing the versatility of the coating agent, it is preferable that the first curable compound can be cured by heat or moisture. That is, the curable compound preferably contains the first curable compound curable with ultraviolet rays and curable with heat or moisture (first curable compound (A)). The curable compound preferably contains the first curable compound having an ultraviolet curable functional group and having a thermosetting functional group or a moisture curable functional group (first curable compound (A)). The first curable compound having a curable functional group other than an ultraviolet curable functional group allows the coating agent to efficiently cure even at a point that is difficult to be cured by ultraviolet rays.

From the viewpoint of enhancing the versatility of the coating agent, the curable compound preferably contains the first curable compound and a second curable compound curable with heat or moisture. In this case, the first curable compound is preferably the first curable compound (B). In this case, the second curable compound is preferably a curable compound having no ultraviolet curable functional group and is preferably a curable compound that is not curable with ultraviolet rays.

Examples of the first curable compound include urethane acrylate-based compounds, polyester acrylate-based compounds, epoxy acrylate-based compounds, polyether acrylate-based compounds, (meth)acryloyl group-containing acryl-based compounds, polythiol-based compounds, and butadiene acrylate-based compounds. From the viewpoint of enhancing the adhesiveness between the circuit board and the hollow particles, the first curable compound is preferably a urethane acrylate-based compound.

The first curable compound (A) may be obtained by introducing a thermosetting functional group or a moisture curable functional group into the first curable compound having neither a thermosetting functional group nor a moisture curable functional group. For example, the first curable compound (A) may be obtained by reacting a first curable compound having neither a thermosetting functional group nor a moisture curable functional group with a reactive reagent capable of imparting moisture curability or thermosetting properties. Examples of the reactive reagent include isocyanate compound, organopolysiloxane, silane coupling agent, cyanoacrylate, organic peroxide, polyamine compound, imidazole compound, isocyanate compound, and thermal cationic polymerization initiator.

Examples of the first curable compound (A) include ultraviolet curable compounds such as a urethane acrylate-based compound, a polyester acrylate-based compound, an epoxy acrylate-based compound, a polyether acrylate-based compound, a (meth)acryloyl group-containing acryl-based compound, a polythiol-based compound, and a butadiene acrylate-based compound, having a thermosetting functional group or a moisture curable functional group such as a moisture curable cyanoacrylate group or a hydrolyzable silyl group.

Examples of the first curable compound (B) include ultraviolet curable compounds such as a urethane acrylate-based compound, a polyester acrylate-based compound, an epoxy acrylate-based compound, a polyether acrylate-based compound, a (meth)acryloyl group-containing acryl-based compound, a polythiol-based compound, and a butadiene acrylate compound, which have neither a thermosetting functional group nor a moisture-curable functional group.

Examples of the second curable compound include a moisture curable urethane resin and a hydrolyzable silyl group-containing resin. From the viewpoint of increasing the curing speed of the coating agent, the second curable compound is more preferably a moisture curable urethane resin. The moisture curable urethane resin has a urethane bond and an isocyanate group, and the isocyanate group reacts with moisture in the air or in the adherend then cures.

The moisture curable urethane resin may have only one isocyanate group or two or more isocyanate groups. The moisture curable urethane resin preferably has isocyanate groups at both ends of the main chain.

The moisture curable urethane resin may be obtained by reacting a polyol compound having two or more hydroxyl groups with a polyisocyanate compound having two or more isocyanate groups, for example.

The reaction between the polyol compound and the polyisocyanate compound is preferably performed such that the molar ratio (isocyanate group/hydroxyl group) of the isocyanate group (NCO group) of the polyisocyanate compound to the hydroxyl group (OH group) of the polyol compound is 2.0 or more and 2.5 or less.

As the polyol compound, a conventionally known polyol compound typically used for producing polyurethane may be used. Examples of the polyol compound include polyester polyols, polyether polyols, polyalkylene polyols, and polycarbonate polyols. One kind of the polyol compound may be used alone, or two or more kinds thereof may be used in combination.

Examples of the polyester polyol include a polyester polyol obtained by reacting a polyvalent carboxylic acid with a polyol, and a poly-ε-caprolactone polyol obtained by ring-opening polymerization of ε-caprolactone.

Examples of the polyvalent carboxylic acid include terephthalic acid, isophthalic acid, 1,5-naphthalic acid, 2,6-naphthalic acid, succinic acid, glutaric acid, adipic acid, pimelic acid, suberic acid, azelaic acid, sebacic acid, decamethylene dicarboxylic acid, and dodecamethylene dicarboxylic acid.

Examples of the polyol include ethylene glycol, propylene glycol, 1,3-propanediol, 1,4-butanediol, neopentyl glycol, 1,5-pentanediol, 1,6-hexanediol, diethylene glycol, and cyclohexanediol.

Examples of the polyether polyol include ring-opening polymers of ethylene glycol, propylene glycol, and tetrahydrofuran, ring-opening polymers of 3-methyltetrahydrofuran, random copolymers or block copolymers of these or derivatives thereof, and bisphenol-type polyoxyalkylene modified products.

The bisphenol-type polyoxyalkylene modified product is a polyether polyol obtained by addition reaction of an alkylene oxide (for example, ethylene oxide, propylene oxide, or butylene oxide) with an active hydrogen moiety of a bisphenol-type molecular skeleton. The bisphenol-type polyoxyalkylene modified product may be a random copolymer or a block copolymer. In the bisphenol-type polyoxyalkylene modified product, one or more alkylene oxides are preferably added to both ends of the bisphenol-type molecular skeleton. The bisphenol type is not particularly limited, and examples thereof include a bisphenol A type, a bisphenol F type, and a bisphenol S type. The bisphenol type is preferably a bisphenol A type.

Examples of the polyalkylene polyol include polybutadiene polyol, hydrogenated polybutadiene polyol, and hydrogenated polyisoprene polyol.

Examples of the polycarbonate polyol include polyhexamethylene carbonate polyol and polycyclohexanedimethylene carbonate polyol.

Examples of the polyisocyanate compound include aromatic polyisocyanate compounds and aliphatic polyisocyanate compounds. Only one kind of the polyisocyanate compound may be used alone, or two or more kinds thereof may be used in combination.

Examples of the aromatic polyisocyanate compound include diphenylmethane diisocyanate, a liquid modified product of diphenylmethane diisocyanate, polymeric MDI, tolylene diisocyanate, and naphthalene-1,5-diisocyanate.

Examples of the aliphatic polyisocyanate compound include hexamethylene diisocyanate, trimethylhexamethylene diisocyanate, lysine diisocyanate, norbornane diisocyanate, transcyclohexane-1,4-diisocyanate, isophorone diisocyanate, hydrogenated xylylene diisocyanate, hydrogenated diphenylmethane diisocyanate, cyclohexane diisocyanate, bis(isocyanatemethyl)cyclohexane, and dicyclohexylmethane diisocyanate.

From the viewpoint of low vapor pressure, low toxicity, and ease of handling, the polyisocyanate compound is preferably diphenylmethane diisocyanate or a modified product thereof.

The curable compound may contain a compound having a structure represented by the following Formula (1).

$$MA-U-A-U-MA \cdots \qquad (1)$$

In Formula (1), MA represents a group containing a moisture curable functional group, A represents a group containing an oily skeleton derived from a hydroxylated vegetable oil, and U represents a group containing a urethane bond. Examples of the moisture curable functional group in MA in Formula (1) include a (meth)acryloyl group and an alkoxy group.

The viscosity of the curable compound at 25°C is preferably 50 mPa·s or more, more preferably 60 mPa·s or more, further preferably 100 mPa.s or more, and preferably 3,000 mPa.s or less, more preferably 2,000 mPa·s or less, further preferably 1,000 mPa·s or less, particularly preferably 500 mPa.s or less. The curable compound having a viscosity at 25°C of the above-described lower limit or more and the above-described upper limit or less can effectively reduce separation of the curable compound and the hollow particles due to the difference in specific gravity, resulting in easy and uniform dispersion of the hollow particles and satisfactory adjustment of the viscosity of the coating agent. As a result, a coating film having a uniform thickness can be satisfactory formed, and the effect of the present invention can be more effectively exhibited.

The viscosity of the curable compound at 25°C may be measured under conditions of 25°C and 5 rpm using an E-type viscometer (for example, "TVE-22L" manufactured by Toki Sangyo Co., Ltd.) or the like.

In the coating agent preparation kit, the content of the curable compound in 100 wt% of the first composition is preferably 50 wt% or more, more preferably 75 wt% or more, and further preferably 90 wt% or more. When the content of the curable compound is the above-described lower limit or more, the effect of the present invention can be more effectively exhibited. In the coating agent preparation kit, the content of the curable compound in 100 wt% of the first composition may be 100 wt%, may be 100 wt% or less, may be less than 100 wt%, may be 95 wt% or less, may be 90 wt% or less, or may be 85 wt% or less.

In the coating agent preparation kit, the content of the first curable compound in 100 wt% of the first composition is preferably 50 wt% or more, more preferably 75 wt% or more, and preferably 100 wt% or less, more preferably 95 wt% or less. When the content of the first curable compound is the above-described lower limit or more and the above-described upper limit or less, the effect of the present invention can be more effectively exhibited.

In the coating agent preparation kit, the content of the second curable compound in 100 wt% of the first composition is preferably more than 0 wt%, more preferably 5 wt% or more, and preferably 50 wt% or less, more preferably 25 wt% or less. When the content of the second curable compound is within the above-described range, the effect of the present invention can be more effectively exhibited.

The content of the curable compound in 100 wt% of the coating agent is preferably 50 wt% or more, more preferably 60 wt% or more, and preferably 95 wt% or less, more preferably 80 wt% or less. When the content of the curable compound is the above-described lower limit or more and the above-described upper limit or less, the effect of the present invention can be more effectively exhibited. When the curable compound contains the first curable compound and the second curable compound, the content of the curable compound in 100 wt% of the coating agent represents the sum of the content of the first curable compound and the content of the second curable compound.

The content of the first curable compound in 100 wt% of the coating agent is preferably 25 wt% or more, more preferably 50 wt% or more, and preferably 95 wt% or less, more preferably 80 wt% or less. When the content of the first curable compound is the above-described lower limit or more and the above-described upper limit or less, the effect of the present invention can be more effectively exhibited.

The content of the second curable compound in 100 wt% of the coating agent is preferably more than 0 wt%, more preferably 5 wt% or more, and preferably 45 wt% or less, more preferably 40 wt% or less. When the content of the second curable compound is within the above-described range, the effect of the present invention can be more effectively exhibited.

<Thickener>

In the coating agent preparation kit, the first composition preferably contains a thickener. The coating agent preferably contains a thickener. Using the thickener can further improve the dispersion stability between the curable compound and the hollow particles in the coating agent. Thus, in the coating film obtained by curing the coating agent, the curable compound and the hollow particles can be present in a more favorable dispersion state, and as a result, the heat insulating properties of the coating can be made uniform. One kind of the thickener may be used alone, or two or more kinds thereof may be used in combination.

Examples of the thickener include aliphatic amide compounds, oxidized polyethylene-based compounds, and polyether phosphoric acid ester-based compounds.

From the viewpoint of more effectively exhibiting the effect of the present invention, the thickener is preferably an aliphatic amide compound.

The aliphatic amide compound is a compound having a -NH-CO-bond. Examples of the aliphatic amide compound include a reaction product of a fatty acid and an aliphatic amine and/or an alicyclic amine, and an oligomer thereof. Since the compound having an amide bond forms a network structure in which hydrogen bonds are involved, it is considered that the formation of the network structure is related to the uniform dispersibility of the hollow particles.

The aliphatic amide compound is preferably an aliphatic amide compound having a fatty acid polyamide structure and having an alkyl group having 8 or more and 30 or less carbon atoms. The alkyl group having 8 or more and 30 or less carbon atoms may be a linear alkyl group or a branched alkyl group. The alkyl group having 8 or more and 30 or less carbon atoms may be a group in which repeating carbon-carbon bonds are connected forming a long chain.

Examples of the aliphatic amide compound include saturated fatty acid monoamides such as lauric acid amide and stearic acid amide, unsaturated fatty acid monoamides such as oleic acid amide, substituted amides such as N-lauryllauric acid amide and N-stearylstearic acid amide, methylol amides such as methylol stearic acid amide, saturated fatty acid bisamides such as methylene bisstearic acid amide, ethylene bislauric acid amide, and ethylene bishydroxystearic acid amide, unsaturated fatty acid bisamides such as methylene bisoleic acid amide, aromatic bisamides such as m-xylylene bisstearic acid amide, ethylene oxide adducts of fatty acid amides, fatty acid ester amides, fatty acid ethanolamides, and substituted ureas such as N-butyl-N'-stearylurea.

From the viewpoint of further improving the dispersibility of the hollow particles, the aliphatic amide compound is preferably a saturated fatty acid monoamide.

As the aliphatic amide compound, a commercially available product may be used. Examples of commercially available products of the aliphatic amide compound include DISPARLON 6900-20X, DISPARLON 6900-10X, DISPARLON A603-20X, DISPARLON A603-10X, DISPARLON A670-20M, DISPARLON 6810-20X, DISPARLON 6850-20X, DISPARLON 6820-20M, DISPARLON 6820-10M, DISPARLON FS-6010, DISPARLON PFA-131, and DISPARLON PFA-231 (all manufactured by Kusumoto Chemicals, Ltd.), FLOWNON RCM-210 (manufactured by KYOEISHA CHEMICAL Co., Ltd.), and BYK-405 (manufactured by BYK Japan KK.).

The polyethylene-based oxide compound is a compound in which some of the hydrogens of methylene is modified to a hydroxyl group or a carboxyl group by bringing polyethylene into contact with oxygen. The polyethylene-based oxide compound has a plurality of hydroxyl groups or a plurality of carboxyl groups, and a hydrogen bond is formed between the oxygen atom of the hydroxyl group or the carboxyl group, and a hydrogen atom. Since the polyethylene oxide compound forms a mesh-like network structure in which hydrogen bonds are involved like this, it is considered that the formation of the network structure relates to the uniform dispersibility of the hollow particles. In the present invention, in particular, a substance in which polyethylene oxide is formed into fine particles to form a colloidal wet dispersion may be suitably used.

As the polyethylene oxide compound, a commercially available product may be used. Examples of commercially available products of the polyethylene oxide compound include DISPARLON PF-920 (manufactured by Kusumoto Chemicals, Ltd.), and FLOWNON SA-300H.

Examples of the polyether phosphoric acid ester-based compound include monoesters or diesters of polyoxyethylene alkyl ether phosphoric acid, polyoxyethylene alkyl phenyl ether phosphoric acid, and higher alcohol phosphoric acid, or alkali metal salts, ammonium salts, and amine salts thereof.

As the polyether phosphoric acid ester-based compound, a commercially available product may be used. Examples of commercially available products of the polyether phosphoric acid ester-based compound include DISPARLON 3500 (manufactured by Kusumoto Chemicals, Ltd.).

In the coating agent preparation kit, the content of the thickener in 100 wt% of the first composition is preferably 0.1 wt% or more, more preferably 0.5 wt% or more, and preferably 10 wt% or less, more preferably 5 wt% or less. When the content of the thickener is the above-described lower limit or more and the above-described upper limit or less, the uniform dispersibility of the hollow particles in the resulting coating agent can be further improved, and as a result, the effect of the present invention can be more effectively exhibited.

The content of the thickener in 100 wt% of the coating agent is preferably 0.05 wt% or more, more preferably 0.25 wt% or more, further preferably 0.5 wt% or more, and preferably 10 wt% or less, more preferably 5 wt% or less, further preferably 4 wt% or less. When the content of the thickener is the above-described lower limit or more and the above-described upper limit or less, the effect of the present invention can be more effectively exhibited.

<Hollow particles>

In the coating agent preparation kit, the second composition includes hollow particles. The coating agent includes hollow particles. Using the hollow particles can impart high heat insulating properties to the coating film formed by the coating agent. One kind of the hollow particles may be used alone, or two or more kinds thereof may be used in combination.

Examples of the hollow particles include balloon particles and porous hollow particles. The balloon particle is a particle having one pore inside the particle. The porous hollow particle is a particle having a plurality of pores inside the particle. The plurality of pores of the porous hollow particles may exist independently, or may exist in a partially connected manner.

From the viewpoint of further improving the heat insulating properties, the hollow particles are preferably balloon particles or porous hollow particles. From the viewpoint of further improving the heat insulating properties, the hollow particles preferably include at least either one of the balloon particles and porous hollow particles. From the viewpoint of increasing the hollow rate and further improving the heat insulating properties, it is more preferable that the hollow particles include balloon particles and porous hollow particles.

The hollow rate of the hollow particles is preferably 40 vol% or more, more preferably 45 vol% or more, and preferably 99 vol% or less, more preferably 80 vol% or less, further preferably 70 vol% or less, particularly preferably 60 vol% or less. When the hollow rate of the hollow particles is the above-described lower limit or more and the above-described upper limit or less, the shape of the hollow particles is well maintained, and as a result, the effect of the present invention can be more effectively exhibited.

The hollow rate of the hollow particles is calculated by the following Formula (X).

$$\text{Hollow rate of hollow particles (vol\%)} = (A - B)/A \times 100 \cdots (X)$$

A: Theoretical density of material constituting hollow particles (g/cm$^3$)
B: Density of hollow particles (g/cm$^3$)

The specific gravity of the hollow particles is preferably 0.1 or more, preferably 5.0 or less, more preferably 4.0 or less, still more preferably 3.0 or less, further preferably 2.0 or less, and particularly preferably 1.5 or less. When the specific gravity of the hollow particles is the above-described lower limit or more and the above-described upper limit or less, the uniform dispersibility of the hollow particles in the coating agent can be further improved, and as a result, the effect of the present invention can be more effectively exhibited.

The specific gravity of the hollow particles means the density of the hollow particles with respect to the density of water (1.0 g/cm$^3$).

The average particle diameter of the hollow particles is preferably 1 um or more, more preferably 5 um or more, further preferably 10 um or more, and preferably 500 um or less, more preferably 100 um or less, further preferably 70 um or less. When the average particle diameter of the hollow particles is the above-described lower limit or more and the above-described upper limit or less, occurrence of slip can be effectively reduced.

The average particle diameter of the hollow particles means an average value (D50) of particle diameters of the hollow particles in a powder state measured by a laser diffraction scattering particle size distribution measuring method.

The hollow particles may be resin-made hollow particles, inorganic hollow particles, or organic hollow particles having glass as a shell. Examples of the resin-made hollow particles include thermoplastic resin particles and thermosetting resin particles. Examples of the inorganic hollow particles include glass particles, Shirasu balloons, flyash balloons, aerogels, and ceramic particles.

From the viewpoint of improving mechanical properties, the hollow particles are preferably thermoplastic resin particles, and more preferably vinyl-based resin particles. The material constituting the hollow particles is preferably a thermoplastic resin, and more preferably a vinyl-based resin. The hollow particles preferably contain a thermoplastic resin, and more preferably contain a vinyl-based resin.

Examples of the monomer constituting the thermoplastic resin include a compound having a styrene skeleton, a compound having a (meth)acryloyl group, vinyl acetate, a vinyl ether compound, a vinyl ketone compound, and an olefin compound. The thermoplastic resin may be a homopolymer in which only one of the compounds (monomers) described above is used or may be a copolymer in which two or more of the compounds (monomers) described above are used.

Examples of the compound having a styrene skeleton include styrene, parachlorostyrene, and α-methylstyrene.

Examples of the compound having a (meth)acryloyl group include a (meth)acrylic acid and a (meth)acrylic acid ester. Examples of the (meth)acrylic acid ester include methyl acrylate, ethyl acrylate, n-propyl acrylate, n-butyl acrylate, lauryl acrylate, nitrile acrylate, 2-ethylhexyl acrylate, methyl methacrylate, ethyl methacrylate, n-propyl methacrylate, lauryl methacrylate, and 2-ethylhexyl methacrylate.

Examples of the vinyl ether compound include vinyl methyl ether and vinyl isobutyl ether.

Examples of the vinyl ketone compound include vinyl methyl ketone, vinyl ethyl ketone, and vinyl isopropenyl ketone.

Examples of the olefin compound include ethylene, propylene, and butadiene.

The material constituting the hollow particles may be a mixture of a non-vinyl-based resin and the vinyl-based resin, a graft polymer obtained by polymerizing a vinyl-based compound in the coexistence of the non-vinyl-based resin and the vinyl-based resin, or the like. Examples of the non-vinyl-based resin include an epoxy resin, a polyester resin, a polyurethane resin, a polyamide resin, a cellulose resin, a polyether resin, and a modified rosin.

From the viewpoint of further improving the heat insulating properties of the coating film, the material constituting the hollow particles is preferably polyacrylonitrile or an acrylic resin. From the viewpoint of further improving the heat insulating properties of the coating film, the hollow particles preferably contain polyacrylonitrile or an acrylic resin.

The hollow particles may be expandable hollow particles or non-expandable hollow particles. The expandable hollow particles are particles in which the volume of the particles (or internal pores) is increased by external stimulation such as heat.

As the hollow particles, a commercially available product may be used. Examples of commercially available products of resin-made hollow particles include ADVANCELL EM, HB (both manufactured by SEKISUI CHEMICAL CO., LTD.), Expancel U, E (both manufactured by Japan Fellite Co., Ltd.), and Matsumoto Microsphere F, F-E (both manufactured by Matsumoto Yushi-Seiyaku Co., Ltd.). Examples of commercially available products of the inorganic hollow particles include SiliNax (manufactured by Nittetsu Mining Co., Ltd.), E-SPHERES (manufactured by TAIHEIYO CEMENT CORPORATION), HardLite (manufactured by Showa Chemical Industry Co., Ltd.), Cenolite, Maarlite, and Glass Balloon (all manufactured by TOMOE Engineering Co., Ltd.).

In the coating agent preparation kit, the content of the hollow particles in 100 wt% of the second composition is preferably 80 wt% or more, and more preferably 90 wt% or more. The content of the hollow particles in 100 wt% of the second composition may be 100 wt%, may be 100 wt% or less, may be less than 100 wt%, may be 90 wt% or less, or may be 80 wt% or less. The hollow particles having a content of the above-described lower limit or more can impart high heat insulating properties to the coating film formed by the coating agent, can further improve the uniform dispersibility of the hollow particles in the coating agent, and can favorably form a coating film having a uniform thickness, and as a result, the effect of the present invention can be more effectively exhibited.

The content of the hollow particles in 100 wt% of the coating agent is preferably 0.1 wt% or more, more preferably 0.5 wt% or more, still more preferably 5 wt% or more, further preferably 10 wt% or more, particularly preferably 20 wt% or more, and preferably 50 wt% or less, more preferably 45 wt% or less, further preferably 40 wt% or less. The hollow particles having a content of the above-described lower limit or more and the above-described upper limit or less can impart high heat insulating properties to the coating film formed by the coating agent, can further improve the uniform dispersibility of the hollow particles in the coating agent, and can favorably form a coating film having a uniform thickness, and as a result, the effect of the present invention can be more effectively exhibited.

The content of the balloon particles in 100 wt% of the coating agent is preferably 0.1 wt% or more, more preferably 0.5 wt% or more, further preferably 1 wt% or more, and preferably 50 wt% or less, more preferably 40 wt% or less, further preferably 30 wt% or less, particularly preferably 10 wt% or less. The balloon particles having a content of the above-described lower limit or more and the above-described upper limit or less can impart high heat insulating properties to the coating film formed by the coating agent, can further improve the uniform dispersibility of the hollow particles in the coating agent, and can favorably form a coating film having a uniform thickness, and as a result, the effect of the present invention can be more effectively exhibited.

The content of the porous hollow particles in 100 wt% of the coating agent is preferably 0.1 wt% or more, more preferably 3 wt% or more, further preferably 5 wt% or more, particularly preferably 10 wt% or more, and preferably 40 wt% or less. The porous hollow particles having a content of the above-described lower limit or more and the above-described upper limit or less can impart high heat insulating properties to the coating film formed by the coating agent, can further improve the uniform dispersibility of the hollow particles in the coating agent, and can favorably form a coating film having a uniform thickness, and as a result, the effect of the present invention can be more effectively exhibited.

<Other components>

In the coating agent preparation kit, the first composition may contain another component different from the curable compound and the thickener. In the coating agent preparation kit, the second composition may contain a component (another component) other than the hollow particles. The coating agent may contain a component (another component) other than these three types of the curable compound, the thickener, and the hollow particles. Examples of the other component include photoinitiators, sensitizers, leveling agents, fluorescent agents, antistatic agents, and fillers. Only one kind of the other component may be used, or two or more kinds thereof may be used in combination.

In the coating agent preparation kit, the first composition preferably contains no organic solvent or contains an organic solvent in an amount of 50 wt% or less. When the first composition contains an organic solvent, the content of the organic solvent in 100 wt% of the first composition is preferably 50 wt% or less, more preferably 40 wt% or less, still more preferably 30 wt% or less, further preferably 20 wt% or less, still further preferably 10 wt% or less, and particularly preferably 5 wt% or less. In 100 wt% of the first composition, the content of the organic solvent may be more than 0 wt%, may be 2.5 wt% or more, or may be 5 wt% or more. In the coating agent preparation kit, it is most preferable that the first composition contains no organic solvent.

In the coating agent preparation kit, the second composition preferably contains no organic solvent or contains an organic solvent in an amount of 20 wt% or less. When the second composition contains an organic solvent, the content of the organic solvent in 100 wt% of the second composition is preferably 20 wt% or less, more preferably 15 wt% or less, further preferably 10 wt% or less, and particularly preferably 5 wt% or less. In 100 wt% of the second composition, the content of the organic solvent may be more than 0 wt%, may be 2.5 wt% or more, or may be 5 wt% or more. In the coating agent preparation kit, it is most preferable that the second composition contains no organic solvent.

The coating agent preferably contains no organic solvent or contains an organic solvent in an amount of 50 wt% or less. When the coating agent contains an organic solvent, the content of the organic solvent in 100 wt% of the coating agent is preferably 50 wt% or less, more preferably 40 wt% or less, still more preferably 30 wt% or less, further preferably 20 wt% or less, still further preferably 10 wt% or less, and particularly preferably 5 wt% or less. It is most preferable that the coating agent contains no organic solvent.

Examples of the organic solvent include acetone, methyl ethyl ketone, alkylcyclohexane, cyclohexene, ethylene glycol, propylene glycol, methyl alcohol, ethyl alcohol, isopropyl alcohol, butanol, benzene, toluene, xylene, ethyl acetate, and butyl acetate.

<Other details>

The coating agent preparation kit is preferably a coating agent preparation kit for a circuit board. The coating agent is preferably a coating agent for a circuit board. The coating agent is preferably used to cover a conductive bonding part (preferably, a solder part) disposed on a surface of the circuit board. The coating agent preparation kit is preferably a coating agent preparation kit for producing an electronic substrate. The coating agent is preferably a coating agent for producing an electronic substrate. The coating agent is preferably used to cover a conductive bonding part (preferably, a solder part) disposed on a surface of a circuit board in an electronic substrate. The coating agent preparation kit is preferably a coating agent preparation kit used for covering the solder. The coating agent is preferably a coating agent used for covering the solder. The coating agent preparation kit is preferably a coating agent preparation kit used for forming a coating film that covers the solder. The coating agent is preferably a coating agent used for forming a coating film that covers the solder.

The sum of the content of the curable compound and the content of the hollow particles in 100 wt% of the coating agent is preferably 80 wt% or more, more preferably 85 wt% or more, and further preferably 90 wt% or more. When the sum of the contents is the above-described lower limit or more, the effect of the present invention can be more effectively exhibited. The sum of the content of the curable compound and the content of the hollow particles in 100 wt% of the coating agent may be 100 wt%, may be 100 wt% or less, may be less than 100 wt%, may be 90 wt% or less, or may be 80 wt% or less.

The sum of the content of the curable compound, the content of the thickener, and the content of the hollow particles in 100 wt% of the coating agent is preferably 80 wt% or more, more preferably 85 wt% or more, and further preferably 90 wt% or more. When the sum of the contents is the above-described lower limit or more, the effect of the present invention can be more effectively exhibited. The sum of the content of the curable compound, the content of the thickener, and the content of the hollow particles in 100 wt% of the coating agent may be 100 wt%, may be 100 wt% or less, may be less than 100 wt%, may be 90 wt% or less, or may be 80 wt% or less.

In the coating agent preparation kit, the mixing ratio of the first composition and the second composition is not limited. From the viewpoint of favorably mixing the first composition and the second composition, it is preferable to obtain the coating agent by mixing the second composition in an amount of preferably 0.05 parts by weight or more, more preferably 0.1 parts by weight or more, and preferably 1 part by weight or less, more preferably 0.8 parts by weight or less, with respect to 1 part by weight of the first composition.

In the coating agent preparation kit, the coating agent obtained by mixing the first composition and the second composition has a viscosity at 25°C of preferably 100 mPa·s or more, more preferably 200 mPa·s or more. In the coating agent preparation kit, the coating agent obtained by mixing the first composition and the second composition has a viscosity at 25°C of preferably 30,000 mPa.s or less, more preferably 20,000 mPa.s or less, further preferably 10,000 mPa·s or less, and particularly preferably 7,500 mPa·s or less. When the viscosity is the above-described lower limit or more, the coating shape of the coating agent disposed on the circuit board or the like can be favorably maintained, and a coating film having a uniform thickness can be favorably formed. When the viscosity is the above-described upper limit or less, the coating agent can be favorably discharged from a dispenser.

The viscosity of the coating agent at 25°C is preferably 100 mPa.s or more, more preferably 200 mPa.s or more, and preferably 30,000 mPa.s or less, more preferably 20,000 mPa.s or less, further preferably 10,000 mPa·s or less, particularly preferably 7,500 mPa·s or less. When the viscosity is the above-described lower limit or more, the coating shape of the coating agent disposed on the circuit board or the like can be favorably maintained, and a coating film having a uniform thickness can be favorably formed. When the viscosity is the above-described upper limit or less, the coating agent can be favorably discharged from a dispenser.

The viscosity of the coating agent at 25°C may be measured under the conditions of 25°C and 5 rpm using an E-type viscometer (for example, "TVE-22L" manufactured by Toki Sangyo Co., Ltd.) or the like. The viscosity of the coating agent at 25°C is measured within 30 minutes after the preparation of the coating agent.

The coating agent preparation kit may be obtained by containing the first composition in a first container and containing the second composition in a second container, for example. The coating agent may be obtained by mixing the first composition and the second composition, for example. The coating agent may be obtained by mixing the curable compound, the thickener, the hollow particles, and other components to be blended as necessary.

A coating film (cured product of the coating agent) may be obtained by curing the coating agent. The method for curing the coating agent may be appropriately changed depending on the type of the curable compound contained in the coating agent, and the like.

(Electronic substrate and method for producing the same)

The electronic substrate according to the present invention includes a circuit board, a solder part disposed on a surface of the circuit board, and a coating film covering the solder part, the coating film being a cured product of the coating agent described above.

An electronic component such as a semiconductor chip may be mounted on the circuit board. A coating film may be formed by disposing the coating agent on a surface soldered for electrical connection between the electronic component and the circuit board and curing the coating agent.

The electronic substrate may include an electronic device but does not have to include an electronic device. The electronic substrate preferably includes an electronic device mounted on a circuit board. It is preferable that the circuit board and the electronic device are electrically connected by the solder part in the electronic substrate. The electronic device is preferably mounted on the circuit board. Examples of the electronic device include a semiconductor device, a resistor chip, a capacitor, and an external connection terminal.

Fig. 1 is a sectional view schematically illustrating an electronic substrate in which the coating agent according to an embodiment of the present invention is used.

An electronic substrate 1 illustrated in Fig. 1 includes a circuit board 2, a solder part 3 disposed on a surface of the circuit board 2, a coating film 4 covering the solder part 3, and an electronic device 5. The coating film 4 is disposed also on a part of the surface of the circuit board 2. In the electronic substrate 1, the circuit board 2 and the electronic device 5 are electrically connected by the solder part 3.

In the electronic substrate, the coating film may cover only a part of the surface of the solder part or may cover the entire surface of the solder part. In the electronic substrate, the coating film is preferably disposed to cover the solder part. In the electronic substrate, the coating film may cover only a part of the surface of the circuit board or may cover the entire surface of the circuit board.

The electronic substrate is preferably an electronic substrate constituting an electronic control unit (ECU). An electronic control unit may be produced by mounting electronic devices such as a semiconductor device, a resistor chip, a capacitor, and an external connection terminal on an electronic substrate such as a wiring substrate, and modularizing electronic components in which the electronic substrate and each electronic device are electrically connected by a conductive bonding member such as solder. The electronic control unit is preferably an electronic control unit for an aircraft or an automobile, and it is more preferably an electronic control unit related to a sensor.

The method for producing the electronic substrate is not limited. The method for producing the electronic substrate preferably includes the following steps. (1) A step of preparing an electronic component in which an electronic device is mounted on a circuit board, and the circuit board and the electronic device are electrically connected by a solder part. (2) A step of disposing the coating agent described above on the surface of the electronic component to cover at least the solder part. (3) A step of forming a coating film by curing the coating agent.

Examples of the method for disposing the coating agent on the surface of the electronic component include a method in which the coating agent is applied with a dispenser and a method by dipping. The thickness of the coating agent layer obtained by disposing the coating agent on the surface of the electronic component is not particularly limited. The thickness of the coating agent layer may be 50 um or more, may be 100 um or more, may be 150 um or more, may be 200 um or more, may be 1,000 um or less, or may be 500 um or less. With the present invention, a relatively thick coating agent layer can be satisfactorily obtained.

The method for curing the coating agent may be appropriately changed depending on the type of the curable compound contained in the coating agent, and the like. Examples of the method for curing the coating agent include a method of irradiating the coating agent (coating agent layer) with ultraviolet rays, a method of heating the coating agent (coating agent layer), and a method of disposing the coating agent then allowing the coating agent to stand and naturally cure. The irradiation intensity at the time of irradiating the coating agent with ultraviolet rays and the heating temperature at the time of heating the coating agent are appropriately set depending on the type of the curable compound and the like.

In the electronic substrate, the hollow particles preferably have a concentration gradient in a thickness direction of the coating film. In the electronic substrate, in the thickness direction of the coating film, it is preferable that the hollow particles are unevenly distributed to be abundantly present on the surface side opposite to the solder part side. In the electronic substrate, the content of the hollow particles in the region having a thickness of 1/2 of the coating film from the outer surface to the inside of the coating film is preferably larger than the content of the hollow particles in the region having a thickness of 1/2 of the coating film from the inner surface to the outside of the coating film. In this case, the insulation resistance can further improve. The inner surface of the coating film is a surface of the coating film on the solder part side (circuit board side), and the outer surface of the coating film is a surface of the coating film on the side opposite from the solder part side (circuit board side).

The coating film may have a one-layer structure, may have a two-layer structure, or may have a structure of two or more layers. When the coating film has a structure of two or more layers, a gradient can be favorably formed in the concentration of the hollow particles in a thickness direction of the coating film.

It is preferable that the coating film includes a first layer and a second layer, and the content of the hollow particles in 100 wt% of the first layer is smaller than the content of the hollow particles in 100 wt% of the second layer. It is preferable that the coating film includes a first layer and a second layer, the content of the hollow particles in 100 wt% of the first layer is less than 1.0 wt%, and the content of the hollow particles in 100 wt% of the second layer is 1.0 wt% or more. In this case, the first layer is a layer in which the content of the hollow particles is less than 1.0 wt%, and the second layer is a layer in which the content of the hollow particles is 1.0 wt% or more. Using a plurality of coating agents having different compositions can form a coating film having the first layer and the second layer. The coating film having the first layer and the second layer can further improve insulation resistance.

In the coating film, the first layer is preferably positioned closer to the solder part than the second layer is. In the coating film, the first layer is preferably positioned on the inner surface side of the coating film, and the second layer is preferably positioned on the outer surface side of the coating film. In this case, the insulation resistance can further improve.

It is preferable that the first layer does not contain the hollow particles or contain the hollow particles in an amount of less than 1.0 wt%. When the first layer contains the hollow particles, the content of the hollow particles in 100 wt% of the first layer is preferably less than 1.0 wt% and more preferably 0.5 wt% or less. When the content of the hollow particles is less than the above-described upper limit or the above-described upper limit or less, the insulation resistance can further improve. It is most preferable that the first layer does not contain the hollow particles.

The content of the hollow particles in 100 wt% of the second layer is preferably 5 wt% or more, more preferably 10 wt% or more, further preferably 20 wt% or more, and preferably 50 wt% or less, more preferably 45 wt% or less, further preferably 40 wt% or less. When the content of the hollow particles is the above-described lower limit or more and the above-described upper limit or less, the insulation resistance can further improve.

The absolute value of the difference between the content of the hollow particles in 100 wt% of the first layer and the content of the hollow particles in 100 wt% of the second layer is preferably 5 wt% or more, more preferably 10 wt% or more, and preferably 50 wt% or less, more preferably 40 wt% or less. When the absolute value of the difference between the contents of the hollow particles is the above-described lower limit or more and the above-described upper limit or less, the insulation resistance can further improve, and the heat insulating properties can further improve.

From the viewpoint of further improving the insulation resistance, the thickness of the first layer is preferably 10 um or more, more preferably 50 um or more, and preferably 250 um or less, more preferably 100 um or less.

From the viewpoint of further improving the heat insulating properties, the thickness of the second layer is preferably 40 um or more, more preferably 50 um or more, and preferably 750 um or less, more preferably 400 um or less.

From the viewpoint of obtaining favorable sealing of the electronic components, the thickness of the coating film is preferably 50 um or more, more preferably 100 um or more, and preferably 1,000 um or less, more preferably 500 um or less.

In the electronic substrate, an insulating layer may be provided on the surface of the solder part. The electronic substrate may include an insulating layer between the solder part and the coating film. In this case, insulation resistance can further improve in the electronic substrate, the electronic component module, and the like.

(Electronic component module and method for producing the same)

An electronic substrate on which an electronic component is mounted is typically contained and integrated in a housing to form an electronic component module to protect the electronic component. Miniaturization of an electronic component module has recently been demanded, and instead of containing an electronic component in a housing, forming an electronic component module in which an electronic component itself is sealed and integrated with a thermoplastic resin has been performed. The electronic component module is produced by disposing an electronic component in a mold and performing injection molding (in-mold molding). However, when the conventional coating agent is used, heat of molten thermoplastic resin transfers to the electronic component during injection molding, the conductive bonding member such as solder may be remelted, and the electronic component may be damaged by partial remelting of the solder. In the present invention, since a coating film having uniform heat insulating properties can be formed by the coating agent, heat is less likely to transfer to the solder or the like, and damage of the electronic component can be reduced. In the present invention, sealing the electronic component with the thermoplastic resin means integrating or protecting the electronic component, sensors, connection terminals with the outside, and the like with the thermoplastic resin, and a part not covered with the thermoplastic resin may exist in the substrate, the sensors, cables, and the like.

The electronic component module includes: an electronic component in which an electronic device is mounted on a circuit board, and the circuit board and the electronic element are electrically connected to each other by a conductive bonding part; a coating film covering at least the conductive bonding part; and a thermoplastic resin part sealing the electronic component. In the electronic component module, the coating film is a cured product of the coating agent described above. In the electronic component module, the conductive bonding part is formed of a conductive bonding member. In the electronic component module, the thermoplastic resin part is formed of a thermoplastic resin.

Examples of the electronic device include a semiconductor device, a resistor chip, a capacitor, and an external connection terminal.

Examples of the conductive bonding member include a resin containing a conductive filler, and solder. The conductive bonding member is preferably solder. Thus, the conductive bonding part formed of the conductive bonding member is preferably a solder part. The solder contains tin (Sn). Examples of the solder include Sn-Pb-based alloys, Sn-Ag-Cu-based alloys, Sn-Zn-Bi-based alloys, and Sn-Zn-Al-based alloys. From the viewpoint of environmental regulations, the solder is preferably a lead-free solder, and more preferably a Sn-Ag-Cu-based alloy, a Sn-Zn-Bi-based alloy, or a Sn-Zn-Al-based alloy.

Examples of the resin in the resin containing a conductive filler include thermosetting resins such as epoxy-based resins and phenol-based resins, and thermoplastic resins such as polyester-based resins, polyolefin-based resins, polyurethane-based resins, and polycarbonate-based resins. Examples of the conductive filler in the resin containing a conductive filler include gold, silver, copper, nickel, and aluminum.

From the viewpoint of improving workability at the time of electrically connecting the circuit board and the electronic device, the melting point of the conductive bonding member is preferably 250°C or less, more preferably 220°C or less, further preferably 200°C or less, and particularly preferably 190°C or less. When a thermosetting resin or the like is used as the resin containing a conductive filler, and the melting point of the thermosetting resin cannot be measured, the heat-resistant temperature is defined as the melting point of the conductive bonding member.

The thermoplastic resin for sealing the electronic component is not particularly limited as long as it is a thermoplastic resin that can be injection-molded. Examples of the thermoplastic resin include a polyacetal resin, a polyamide resin, a polycarbonate resin, a polybutylene terephthalate resin, a polyethylene terephthalate resin, a polyphenylene sulfide resin, an acrylic resin, and an ABS resin. From the viewpoint of improving moldability and mechanical properties, the thermoplastic resin is preferably a polybutylene terephthalate resin.

A method for producing the electronic component module is not limited. The method for producing the electronic component module preferably includes the following steps. (1) A step of preparing an electronic component in which an electronic device is mounted on a circuit board, and the circuit board and the electronic device are electrically connected by a conductive bonding part. (2) A step of disposing the coating agent described above on the surface of the electronic component to cover at least the conductive bonding part. (3) A step of forming a coating film by curing the coating agent. (4) A step of disposing the electronic component on which the coating film is formed in a mold and performing injection molding to seal, with a thermoplastic resin, the electronic component on which the coating film is formed.

As the electronic component prepared in the above (1), an electronic component produced by a conventionally known method for producing an electronic component may be used.

Examples of the method for disposing the coating agent on the surface of the electronic component in the above (2) include a method in which the coating agent is applied with a dispenser and a method by dipping. From the viewpoint of protecting the electronic device from heat, the coating agent is preferably disposed to cover the conductive bonding part and the entire circuit board on which the electronic device is mounted. The thickness of the coating agent layer obtained by disposing the coating agent on the surface of the electronic component is not particularly limited. The thickness of the coating agent layer may be 50 um or more, may be 100 um or more, may be 150 pm or more, may be 200 um or more, may be 1,000 um or less, or may be 500 um or less. With the present invention, a relatively thick coating agent layer can be satisfactorily obtained.

The method for curing the coating agent in the above (3) may be appropriately changed depending on the type or the like of the curable compound contained in the coating agent. Examples of the method for curing the coating agent include a method of irradiating the coating agent (coating agent layer) with ultraviolet rays, a method of heating the coating agent (coating agent layer), and a method of disposing the coating agent then allowing the coating agent to stand and naturally cure. The irradiation intensity at the time of irradiating the coating agent with ultraviolet rays and the heating temperature at the time of heating the coating agent are appropriately set depending on the type of the curable compound and the like.

Examples of the method for sealing the electronic component by injection molding in the above (4) include insert injection molding. The insert injection molding may be performed only once or a plurality of times. When the insert injection molding is performed a plurality of times, it is preferable to use a plurality of thermoplastic resins having different molding temperatures.

An electronic component module having a desired shape may be thus produced.

Hereinafter, the present invention will be specifically described with reference to Examples and Comparative Examples. The present invention is not limited to the following Examples.

The following materials were prepared.

(Curable compound)

Curable compound 1 curable with ultraviolet rays ("MX-313" manufactured by Sanyu Rec Co., Ltd., viscosity at 25°C: 3,000 mPa·s)

Curable compound 2 curable with heat ("E-800" manufactured by Sanyu Rec Co., Ltd., viscosity at 25°C: 190 mPa·s)

Curable compound 3 curable with ultraviolet rays or moisture ("MX-300L" manufactured by Sanyu Rec Co., Ltd., viscosity at 25°C: 60 mPa·s)

Curable compound 4 curable with ultraviolet rays ("NSC-7312" manufactured by Nippon Fine Chemical Co., Ltd., viscosity at 25°C: 19 mPa·s)

Curable compound 5 curable with ultraviolet rays (1 part by weight of "Omnirad TPO H" manufactured by IGM Resins was added to 100 parts by weight of "EBECRYL 3700" manufactured by DAICEL-ALLNEX LTD., viscosity at 25°C: 4,000 mPa·s)

The viscosity of the curable compounds at 25°C is a value measured under conditions of 25°C and 5 rpm using an E-type viscometer ("TVE-22L" manufactured by Toki Sangyo Co., Ltd.).

(Thickener)

Aliphatic amide compound 1 ("DISPARLON PFA-131" manufactured by Kusumoto Chemicals, Ltd.)

Aliphatic amide compound 2 ("FLOWNON RCM-210" manufactured by KYOEISHA CHEMICAL Co., Ltd.)

(Hollow particles)

Hollow particle 1 ("ADVANCELL HB-2051" manufactured by SEKISUI CHEMICAL CO., LTD., porous hollow particles, material: polyacrylonitrile, specific gravity: 0.4 $g/cm^3$, hollow rate: 50 vol%, average particle diameter: 20 um)

Hollow particles 2 ("Q-cel 7040s" manufactured by Potters-Ballotini Co., Ltd., balloon particles, material: Na borosilicate glass particles, specific gravity: 0.4 $g/cm^3$, average particle diameter: 45 um)

Hollow particle 3 ("ADVANCELL EM-101" manufactured by SEKISUI CHEMICAL CO., LTD., balloon particles, material: polyacrylonitrile, specific gravity: 0.02 $g/cm^3$, hollow rate: 98 vol%, average particle diameter: 100 um)

(Example 1)

(1) Preparation of coating agent preparation kit

A mixture of 72.7 parts by weight of the curable compound 1 and 2.3 parts by weight of the aliphatic amide compound 1 was contained in a first container to obtain a first composition contained in the first container. The hollow particles 1 in an amount of 25 parts by weight was contained in a second container to obtain a second composition contained in the second container. A coating agent preparation kit having the first composition and the second composition was thus prepared.

(2) Preparation of coating agent

The first composition and the second composition in the obtained coating agent preparation kit were mixed to prepare a coating agent containing each component in the content shown in Table 1 below.

(3) Production of electronic substrate

The obtained coating agent was weighed using a pipettor, and the coating agent was applied onto a substrate such that the thickness of the resulting coating agent layer was 200 um. The coating agent layer was irradiated with ultraviolet rays having an irradiation intensity of 140 mW/cm$^2$ for 1 minute and cured. An electronic substrate was thus produced.

(4) Production of electronic component module

The obtained electronic substrate was set in a mold for insert injection molding, and injection molding was performed to obtain an electronic component module.

(Examples 2 to 15)

Coating agent preparation kits were prepared in the same manner as in Example 1 except that the first composition and the second composition were obtained such that the coating agent obtained by mixing the first composition and the second composition contained each component in the contents shown in Tables 1 to 3 below. The first composition and the second composition in each obtained coating agent preparation kit were mixed to prepare a coating agent containing each component in the content shown in Tables 1 to 3 below. Electronic substrates and electronic component modules were obtained in the same manner as in Example 1 except that the obtained coating agents were used.

(Comparative Examples 1 to 6)

Electronic substrates and electronic component modules were obtained in the same manner as in Example 1 except that the curable compounds or the mixture of the curable compounds and the thickeners shown in Table 4 below were used as the coating agent.

(Evaluation)

(1) Viscosity of coating agent at 25°C

The viscosity of each coating agent at 25°C was measured using an E-type viscometer ("TVE-22L" manufactured by Toki Sangyo Co., Ltd.) under the conditions of 25°C and 5 rpm. The viscosity of the coating agent at 25°C was measured within 30 minutes after the preparation of the coating agent.

(2) Phase separation of coating agent

The coating agent immediately after preparation was allowed to stand in a transparent container for 5 minutes. The separation state between the curable compound and the hollow particles in the coating agent after standing was visually observed. The phase separation of the coating agent was determined according to the following criteria. Comparative Examples 1 to 3, 5, and 6 containing only a curable compound were "- (undeterminable)".

[Criteria for determining phase separation of coating agent]

∘: No separation of liquid phase and particle phase is observed.
×: Some of the hollow particles floats, and a separation of a liquid phase and a phase including the hollow particles is observed (a transparent liquid layer was generated in the lowermost layer).

(3) Formability of coating agent layer and coating film

(3-1) Coatability of coating agent (formability of coating agent layer)

The coating agent in an amount of 10.0 mL was applied onto the surface of a substrate of 10 cm × 10 cm using a bar coater with a spacing of 1.0 mm. The coatability of the coating agent was determined according to the following criteria.

[Criteria for determining coatability of coating agent]

∘: The coating agent can be applied to the entire surface of the substrate without causing fading or coating leakage.
×: 1) The coating agent cannot be applied to the entire surface of the substrate without flowing on the surface of the substrate, or 2) Fading or coating leakage occurs, and there is a region where the coating agent is not applied on the surface of the substrate.

(3-2) Formability of coating film

The coating agent having a predetermined weight was applied to a 2 cm × 2 cm substrate and uniformly spread. A coating film was formed by irradiating the coating agent layer with ultraviolet rays having an irradiation intensity of 140 mW/cm$^2$ for 1 minute and curing the coating agent layer. As the thickness of the coating agent layer with one application of the coating agent can be increased, a coating agent layer (coating film) having a desired thickness can be more easily formed. A coating film having a thickness of 200 um was formed in the same manner, and the thermal conductivity was measured by the transient hot wire method. The formability of the coating film having thermal insulation properties was determined according to the following criteria.

[Criteria for determining formability of coating film]

∘: A coating agent layer having a thickness of 500 um or more can be formed by applying the coating agent once, and the thermal conductivity of the coating film is 0.16 W/m·K or less.
×: A coating agent layer having a thickness of 500 um or more cannot be formed by applying the coating agent once, or the thermal conductivity of the coating film exceeds 0.16 W/m·K.

(4) Remelting of solder

Remelting of the solder was determined according to the following criteria based on the evaluations of (2) Phase separation of coating agent, (3-1) Coatability of coating agent, and (3-2) Formability of coating film.

[Criteria for determining remelting of solder]

∘: All the evaluations of the (2), (3-1) and (3-2) are o.
×: At least one of the evaluations of (2), (3-1), and (3-2) is ×.

The compositions and results are shown in Tables 1 to 4 below.

[Table 1]

| | | | | Example 1 | Example 2 | Example 3 | Example 4 | Example 5 |
|---|---|---|---|---|---|---|---|---|
| Coating agent | Curable compound | Curable compound 1 | wt% | 72.7 | | | | |
| | | Curable compound 2 | wt% | | 72.7 | | | |
| | | Curable compound 3 | wt% | | | 58.2 | 60 | 72.7 |
| | | Curable compound 4 | wt% | | | | | |
| | | Curable compound 5 | wt% | | | | | |
| | Thickener | Aliphatic amide compound 1 | wt% | 2.3 | 2.3 | 1.8 | | |
| | | Aliphatic amide compound 2 | wt% | | | | | 2.3 |
| | Hollow particles | Hollow particles 1 | wt% | 25 | 25 | 40 | 40 | 25 |
| | | Hollow particles 2 | wt% | | | | | |
| | | Hollow particles 3 | wt% | | | | | |
| | Total | | wt% | 100.0 | 100.0 | 100.0 | 100.0 | 100.0 |
| Viscosity of coating agent at 25°C | | | mPa·s | 25333 | 13700 | 7300 | 6000 | 1625 |
| Phase separation of coating agent | | | - | ○ | ○ | ○ | ○ | ○ |
| Coatability of coating agent (formability of coating agent layer) | | | - | ○ | ○ | ○ | ○ | ○ |
| Formability of coating film | Thermal conductivity | | W/m·K | 0.13 | 0.07 | 0.10 | 0.10 | 0.13 |
| | Determinati on | | - | ○ | ○ | ○ | ○ | ○ |
| Remelting of solder | | | - | ○ | ○ | ○ | ○ | ○ |

[Table 2]

| | | | | Example 6 | Example 7 | Example 8 | Example 9 | Example 10 |
|---|---|---|---|---|---|---|---|---|
| Coating agent | Curable compound | Curable compound 1 | wt% | | | | | |
| | | Curable compound 2 | wt% | | | | | |
| | | Curable compound 3 | wt% | 75 | 72.7 | 75 | 95 | 76.6 |
| | | Curable compound 4 | wt% | | | | | |
| | | Curable compound 5 | wt% | | | | | |
| | Thickener | Aliphatic amide compound 1 | wt% | | 2.3 | | | 2.4 |
| | | Aliphatic amide compound 2 | wt% | | | | | |
| | Hollow particles | Hollow particles 1 | wt% | | 25 | 25 | 5 | 20 |
| | | Hollow particles 2 | wt% | 25 | | | | |
| | | Hollow particles 3 | wt% | | | | | 1 |
| | Total | | wt% | 100.0 | 100.0 | 100.0 | 100.0 | 100.0 |
| Viscosity of coating agent at 25°C | | | mPa·s | 1442 | 960 | 440 | 100 | 390 |
| Phase separation of coating agent | | | - | ○ | ○ | ○ | ○ | ○ |
| Coatability of coating agent (formability of coating agent layer) | | | - | ○ | ○ | ○ | ○ | ○ |
| Formability of coating film | Thermal conductivity | | W/m·K | 0.15 | 0.11 | 0.13 | 0.16 | 0.11 |
| | Determination | | - | ○ | ○ | ○ | ○ | ○ |
| Remelting of solder | | | - | ○ | ○ | ○ | ○ | ○ |

[Table 3]

| | | | | Example 11 | Example 12 | Example 13 | Example 14 | Example 15 |
|---|---|---|---|---|---|---|---|---|
| Coating agent | Curable compound | Curable compound 1 | wt% | | | | | |
| | | Curable compound 2 | wt% | | | | | |
| | | Curable compound 3 | wt% | 94.1 | 96.9 | 96.5 | 77.6 | 48.5 |
| | | Curable compound 4 | wt% | | | | | |
| | | Curable compound 5 | wt% | | | | | |
| | Thickener | Aliphatic amide compound 1 | wt% | 2.9 | 3.0 | 3.0 | 2.4 | 1.5 |
| | | Aliphatic amide compound 2 | wt% | | | | | |
| | Hollow particles | Hollow particles 1 | wt% | 3 | | | | |
| | | Hollow particles 2 | wt% | | | | | |
| | | Hollow particles 3 | wt% | | 0.1 | 0.5 | 20 | 50 |
| | Total | | wt% | 100.0 | 100.0 | 100.0 | 100.0 | 100.0 |
| Viscosity of coating agent at 25°C | | | mPa·s | 167 | 160 | 205 | 271 | 4613 |
| Phase separation of coating agent | | | - | ○ | ○ | ○ | ○ | ○ |
| Coatability of coating agent (formability of coating agent layer) | | | - | ○ | ○ | ○ | ○ | ○ |
| Formability of coating film | Thermal conductivity | | W/m·K | 0.16 | 0.16 | 0.14 | 0.15 | 0.09 |
| | Determination | | - | ○ | ○ | ○ | ○ | ○ |
| Remelting of solder | | | - | ○ | ○ | ○ | ○ | ○ |

[Table 4]

| | | | | Comparative Example 1 | Comparative Example 2 | Comparative Example 3 | Comparative Example 4 | Comparative Example 5 | Comparative Example 6 |
|---|---|---|---|---|---|---|---|---|---|
| Coating agent | Curable compound | Curable compound 1 | wt% | 100 | | | | | |
| | | Curable compound 2 | wt% | | 100 | | | | |
| | | Curable compound 3 | wt% | | | 100 | 97 | | |
| | | Curable compound 4 | wt% | | | | | 100 | |
| | | Curable compound 5 | wt% | | | | | | 100 |
| | Thickener | Aliphatic amide compound 1 | wt% | | | | 3 | | |
| | | Aliphatic amide compound 2 | wt% | | | | | | |
| | Hollow particles | Hollow particles 1 | wt% | | | | | | |
| | | Hollow particles 2 | wt% | | | | | | |
| | | Hollow particles 3 | wt% | | | | | | |
| | | Total | wt% | 100.0 | 100.0 | 100.0 | 100.0 | 100.0 | 100.0 |
| Viscosity of coating agent at 25°C | | | mPa·s | 3000 | 190 | 60 | 140 | 19 | 4000 |
| Phase separation of coating agent | | | - | - | - | - | ○ | - | - |
| Coatability of coating agent (formability of coating agent layer) | | | - | ○ | ○ | ○ | ○ | × | × |
| Formability of coating film | | Thermal conductivity | W/m·K | 0.17 | 0.18 | 0.18 | 0.18 | 0.17 | 0.21 |
| | | Determination | - | × | × | × | × | × | × |
| Remelting of solder | | | - | × | × | × | × | × | × |

**EXPLANATION OF SYMBOLS**

1: Electronic substrate
2: Circuit board
3: Solder part
4: Coating film
5: Electronic device

**Claims**

1. A coating agent preparation kit for obtaining a coating agent by mixing, the coating agent preparation kit comprising a first composition and a second composition,

   the first composition including a curable compound curable with ultraviolet rays, heat, or moisture, and
   the second composition including hollow particles.

2. The coating agent preparation kit according to claim 1, wherein the curable compound has a viscosity at 25°C of 50 mPa·s or more and 3,000 mPa·s or less.

3. The coating agent preparation kit according to claim 1 or 2, wherein a coating agent obtained by mixing the first composition and the second composition has a viscosity at 25°C of 100 mPa·s or more and 30,000 mPa·s or less.

4. A coating agent comprising:

   a curable compound curable with ultraviolet rays, heat, or moisture; and
   hollow particles.

5. The coating agent according to claim 4, wherein

   the curable compound has a viscosity at 25°C of 50 mPa·s or more and 3,000 mPa·s or less, and
   the coating agent has a viscosity at 25°C of 100 mPa·s or more and 30,000 mPa·s or less.

6. The coating agent according to claim 4 or 5, wherein

   the hollow particles are balloon particles or porous hollow particles,
   when the balloon particles are contained, a content of the balloon particles is 0.5 wt% or more and 50 wt% or less in 100 wt% of the coating agent, and
   when the porous hollow particles are contained, a content of the porous hollow particles is 5 wt% or more and 40 wt% or less in 100 wt% of the coating agent.

7. The coating agent according to claim 6, wherein

   the hollow particles include balloon particles and porous hollow particles,
   a content of the balloon particles is 0.5 wt% or more and 10 wt% or less in 100 wt% of the coating agent, and
   a content of the porous hollow particles is 5 wt% or more and 40 wt% or less in 100 wt% of the coating agent.

8. The coating agent according to any one of claims 4 to 7, wherein the hollow particles have a hollow rate of 40 vol% or more and 99 vol% or less.

9. The coating agent according to any one of claims 4 to 8, wherein the hollow particles contain polyacrylonitrile or an acrylic resin.

10. The coating agent according to any one of claims 4 to 9, wherein the curable compound includes a first curable compound curable with ultraviolet rays.

**11.** The coating agent according to claim 10, wherein the first curable compound is curable with ultraviolet rays and curable with heat or moisture.

**12.** The coating agent according to any one of claims 4 to 11, the coating agent being for a circuit board.

**13.** An electronic substrate comprising:

a circuit board;
a solder part disposed on a surface of the circuit board; and
a coating film covering the solder part,
the coating film being a cured product of the coating agent according to any one of claims 4 to 12.

**14.** The electronic substrate according to claim 13, wherein

the electronic substrate includes an electronic device mounted on the circuit board, and
the circuit board and the electronic device are electrically connected by the solder part.

**15.** The electronic substrate according to claim 13 or 14, wherein in a thickness direction of the coating film, the hollow particles are unevenly distributed to be abundantly present on a surface side opposite to the solder part side.

**16.** The electronic substrate according to any one of claims 13 to 15, wherein

the coating film includes a first layer and a second layer,
a content of the hollow particles is less than 1.0 wt% in 100 wt% of the first layer, and
a content of the hollow particles is 1.0 wt% or more in 100 wt% of the second layer.

**17.** The electronic substrate according to claim 16, wherein in the coating film, the first layer is positioned closer to the solder part than the second layer is.

**18.** A method for producing an electronic component module, the method comprising:

a step of preparing an electronic component in which an electronic device is mounted on a circuit board and the circuit board and the electronic device are electrically connected to each other by a conductive bonding part;
a step of disposing the coating agent according to any one of claims 4 to 12 on a surface of the electronic component to cover at least the conductive bonding part;
a step of forming a coating film by curing the coating agent; and
a step of disposing, in a mold, the electronic component on which the coating film is formed and performing injection molding to seal, with a thermoplastic resin, the electronic component on which the coating film is formed.

**19.** The method for producing an electronic component module according to claim 18, wherein the conductive bonding part is a solder part.

[FIG. 1]

## INTERNATIONAL SEARCH REPORT

International application No.

**PCT/JP2022/009377**

| A. | CLASSIFICATION OF SUBJECT MATTER |
|---|---|

*C09D 201/00*(2006.01)i; *H01L 21/60*(2006.01)i; *C09D 7/40*(2018.01)i; *C09D 7/61*(2018.01)i; *C09D 7/65*(2018.01)i; *H05K 3/00*(2006.01)i; *H05K 3/28*(2006.01)i
FI:   C09D201/00; C09D7/40; C09D7/65; H05K3/28 G; H05K3/00 W; H01L21/60 311S; C09D7/61

According to International Patent Classification (IPC) or to both national classification and IPC

| B. | FIELDS SEARCHED |
|---|---|

Minimum documentation searched (classification system followed by classification symbols)

C09D1/00-10/00; C09D101/00-201/10; H01L21/447-21/449; H01L21/60-21/607; H05K3/00; H05K3/28

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | US 2014/0345923 A1 (MILLER, Dennis, J.) 27 November 2014 (2014-11-27) | 1-6, 8, 12-15 |
| A | claims 1-3, 9-10, paragraphs [0016]-[0021], fig. 2-4 | 7, 9-11, 16-19 |
| X | JP 2011-75786 A (SEKISUI CHEM. CO., LTD.) 14 April 2011 (2011-04-14) | 1-10, 12 |
| A | claims 1-6, paragraphs [0008], [0038], [0042], [0070], [0077], examples 1-14 | 11, 13-19 |
| X | JP 2007-56158 A (NAGOYA INST. OF TECHNOLOGY) 08 March 2007 (2007-03-08) | 1-6, 8, 12 |
| A | claims 1-4, paragraphs [0001], [0008], [0054]-[0057], examples 1-2 | 7, 9-11, 13-19 |
| X | JP 2008-251500 A (MATSUSHITA ELECTRIC WORKS LTD.) 16 October 2008 (2008-10-16) | 1-6, 8, 10-11 |
| A | claims 1, 8, paragraph [0030], examples 1-7 | 7, 9, 12-19 |

☑ Further documents are listed in the continuation of Box C.     ☑ See patent family annex.

| \* | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **11 May 2022** | **24 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

25

EP 4 306 603 A1

**INTERNATIONAL SEARCH REPORT**

International application No.

**PCT/JP2022/009377**

## C. DOCUMENTS CONSIDERED TO BE RELEVANT

| Category* | Citation of document, with indication, where appropriate, of the relevant passages | Relevant to claim No. |
|---|---|---|
| X | JP 7-232131 A (TAKIRON CO., LTD.) 05 September 1995 (1995-09-05) claim 1, paragraphs [0017], [0022], example 1 | 4-6, 8, 10 |
| A | | 1-3, 7, 9, 11-19 |

## INTERNATIONAL SEARCH REPORT
### Information on patent family members

International application No.

**PCT/JP2022/009377**

| Patent document cited in search report | | | Publication date (day/month/year) | Patent family member(s) | Publication date (day/month/year) |
|---|---|---|---|---|---|
| US | 2014/0345923 | A1 | 27 November 2014 | (Family: none) | |
| JP | 2011-75786 | A | 14 April 2011 | (Family: none) | |
| JP | 2007-56158 | A | 08 March 2007 | (Family: none) | |
| JP | 2008-251500 | A | 16 October 2008 | US 2010/0060142 A1 claims 1, 8, paragraph [0020], practical examples 1-7 <br> EP 2141962 A1 <br> CN 101647316 A <br> KR 10-2009-0128487 A | |
| JP | 7-232131 | A | 05 September 1995 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017038343 A1